(19) **Europäisches Patentamt European Patent Office Office européen des brevets**

(11) **EP 3 306 678 B1**

(12) **FASCICULE DE BREVET EUROPEEN**

(45) Date de publication et mention de la délivrance du brevet:
**15.05.2019 Bulletin 2019/20**

(51) Int Cl.:
***H01L 31/105*** *(2006.01)* ***G02B 6/12*** *(2006.01)*
***H01L 31/107*** *(2006.01)*

(21) Numéro de dépôt: **17195579.2**

(22) Date de dépôt: **10.10.2017**

(54) **PHOTODIODE**

FOTODIODE

PHOTODIODE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.10.2016 FR 1659767**

(43) Date de publication de la demande:
**11.04.2018 Bulletin 2018/15**

(73) Titulaire: **Commissariat à l'Energie Atomique et aux Energies Alternatives**
**75015 Paris (FR)**

(72) Inventeurs:
• **BOUTAMI, Salim**
**38100 Grenoble (FR)**
• **HASSAN, Karim**
**89470 Moneteau (FR)**
• **KARAKUS, Bayram**
**38400 Saint Martin d'Hères (FR)**

(74) Mandataire: **Hautier, Nicolas**
**Cabinet Hautier**
**20, rue de la Liberté**
**06000 Nice (FR)**

(56) Documents cités:
JP-A- 2006 173 329     JP-A- 2014 216 549
US-A1- 2008 310 790     US-A1- 2015 069 565
US-A1- 2016 254 407

**Description**

DOMAINE TECHNIQUE DE L'INVENTION

L'invention concerne de manière générale les photodiodes.

Elle trouvera pour application particulièrement avantageuse le domaine des photodiodes. Elle confère en outre des avantages significatifs lorsqu'elle est appliquée aux photodiodes à avalanche.

ÉTAT DE LA TECHNIQUE

De manière classique une photodiode comprend une portion d'absorption à l'intérieur de laquelle des photons sont introduits pour générer des porteurs de charges électriques. Cette portion d'absorption est généralement faite en germanium (Ge).

Compte tenu du coefficient d'absorption du germanium, il faut que la photodiode présente une longueur, prise selon la direction de propagation de la lumière, qui soit relativement importante pour absorber une quantité satisfaisante de lumière et donc pour être performante en termes de sensibilité. Cette longueur a un impact direct sur la largeur de la bande passante de la photodiode. En effet la longueur de la portion d'absorption diminue la largeur de la bande passante.

Il est donc nécessaire de trouver un compromis entre absorptivité et bande passante.

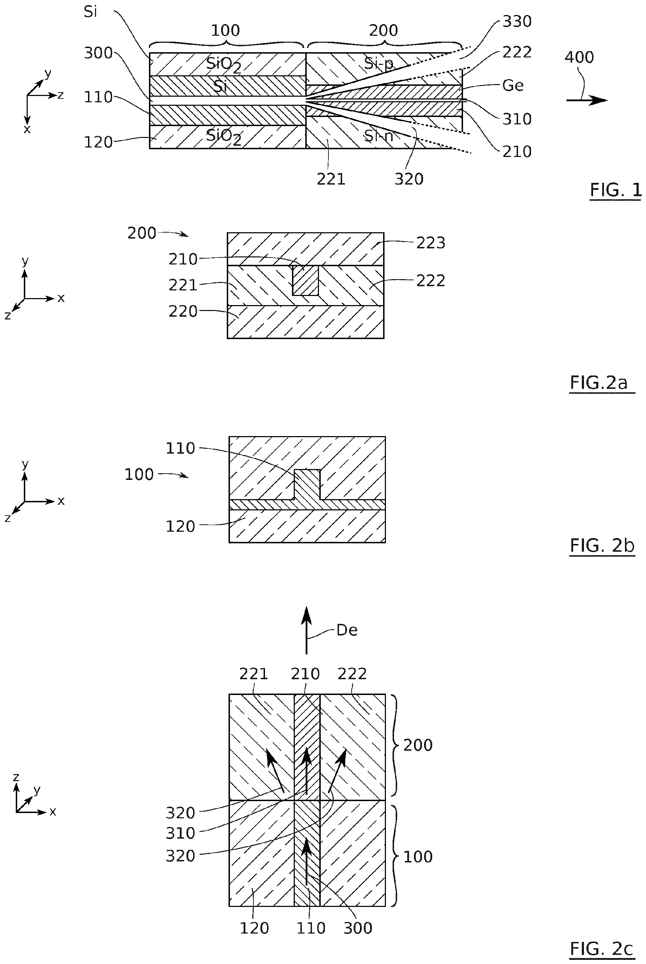

Certaines photodiodes, qualifiées de photodiodes à double hétérojonction, prévoient de confiner le matériau responsable de l'absorption des photons et leur transformation en porteurs de charges, à l'intérieur d'une gaine. Ce type de photodiode est illustré en **figures 1 et 2a à 2c**.

Dans ce type de photodiode, un premier guide d'ondes, qualifié de guide d'injection 100, est formé d'une part d'un coeur 110 en silicium (Si) à l'intérieur duquel le faisceau lumineux est destiné à se propager et d'autre part d'une gaine 120 de silice (SiO$_2$) enrobant le coeur 110. La photodiode comprend un deuxième guide d'ondes, qualifié de portion d'absorption 200, au sein duquel s'effectuent l'absorption des photons, la génération de charges électriques et l'extraction de ces dernières. Ce deuxième guide formant portion d'absorption 200 comprend un coeur 210 en germanium intrinsèque (Ge-i) et une gaine 220 présentant deux zones d'extraction 221, 222 de silicium (Si) dopées respectivement n et p et situées de part et d'autre du coeur 210. C'est plus précisément le coeur 210 en germanium qui fait office de zone de conversion puisqu'il absorbe les photons et rend mobile les porteurs de charges électriques.

Ce type de photodiode permet de limiter la diffusion des rayons lumineux dans la gaine 220 et de mieux les confiner à l'intérieur du coeur 210 en germanium. Cela contribue à améliorer l'absorptivité de la photodiode et donc sa sensibilité par rapport aux photodiodes standards.

Néanmoins, comme cela apparaît sur les figures **1 et 2c** illustrant de manière schématique des simulations, une partie 320 des ondes lumineuses qui pénètrent dans le deuxième guide 200 se diffuse dans la gaine 220 au sein des portions 221, 222. Ces ondes lumineuses 320 diffusées ne sont donc pas absorbées par le coeur 210 de germanium et limitent ainsi les performances de la photodiode en termes de responsivité.

Ce type de photodiode à double hétérojonction a apporté des améliorations significatives par rapport aux photodiodes classiques.

Néanmoins, afin d'atteindre une absorptivité satisfaisante, la portion d'absorption de ces photodiodes à double hétérojonction doit inévitablement présenter une longueur importante, ce qui limite de manière préjudiciable la largeur de la bande passante.

Par exemple, afin qu'une photodiode Si-n/Ge-i/Si-p comme décrit ci-dessus et représentée en figures 1 à 2c absorbe 90% d'une lumière dont la longueur d'onde de À est de 1.55 $\mu$m (10$^{-6}$ mètres) (cette longueur d'onde correspondant à une longueur d'onde typique dans le domaine des télécommunications), il faut que le coeur 210 en germanium présente une longueur, selon l'axe z, de presque 100 $\mu$m.

Il existe donc un besoin consistant à proposer une solution pour réduire la longueur de la portion d'absorption d'une photodiode sans pour autant limiter de manière trop significative la largeur de sa bande passante.

Tel est l'objectif de la présente invention.

Les autres objets, caractéristiques et avantages de la présente invention apparaîtront à l'examen de la description suivante et des dessins d'accompagnement. Il est entendu que d'autres avantages peuvent être incorporés.

Le document US20160254407, divulgue un exemple de photodiode présentant un arrangement de structures périodiques au niveau de sa zone d'absorption.

RÉSUMÉ DE L'INVENTION

La photodiode de la présente invention est définie dans la revendication 1.

Selon un mode de réalisation, l'invention porte sur une photodiode comprenant au moins une portion d'absorption, la portion d'absorption comportant au moins un coeur de préférence entouré au moins en partie d'une gaine comprenant au moins deux zones d'extraction de charges, le coeur comprenant :

- une pluralité de motifs formés d'un premier matériau ayant la propriété de générer en son sein des porteurs de charges électriques libres à partir d'une absorption de photons;
- une couche de confinement à l'intérieur de laquelle sont situés les motifs, la couche de confinement étant formée d'un deuxième matériau différent du premier et apte à être rendu électriquement conducteur.

Par ailleurs, les motifs sont disposés de manière périodique selon une direction principale De (z) d'extension dudit coeur, en présentant un pas p.

Ainsi, l'invention prévoit un coeur structuré par des inclusions d'un matériau convertisseur de photons. Le coeur de la portion d'absorption n'est pas homogène. Les inclusions ponctuelles du premier matériau le long de la direction principale De et selon un pas p faible engendrent des réflexions multiples des photons en limitant la propagation par diffraction dans les zones d'extraction. Le trajet parcouru par les photons s'en trouve ainsi rallongé. La structuration du coeur par la pluralité de motifs disposés permet ainsi un ralentissement de la propagation du flux lumineux. La lumière est alors absorbée sur une plus courte distance selon la direction principale De (z).

De préférence le pas p des motifs est suffisamment faible pour que la propagation du flux lumineux s'effectue principalement et selon un phénomène de lumière lente, c'est-à-dire sans diffraction dans la gaine. La propagation le long de la direction principale De (z) s'effectue alors comme si le coeur était homogène alors qu'il comporte en réalité de multiples inclusions dans une couche de confinement.

Ainsi l'invention permet d'améliorer l'absorptivité de la photodiode sans avoir à rallonger sa longueur et donc sans réduire sa bande passante.

Autrement dit, à absorptivité et donc à sensibilité constante, l'invention permet de réduire la longueur de la photodiode et donc d'augmenter la largeur de sa bande passante.

Ce résultat, qui sera détaillé par la suite, est totalement contre intuitif. En effet, il était prévisible qu'une réduction de la quantité de matériau absorbant conduirait à une diminution de l'absorptivité. En aucune manière il n'était envisageable qu'une réduction de la quantité de matériau absorbant ne dégraderait pas fortement l'absorptivité. A fortiori, il n'était pas prévu que cette réduction de la quantité de matériau absorbant pourrait conduire à une augmentation de l'absorptivité.

Par ailleurs, cette structure de photodiode présente pour avantage de réduire le courant d'obscurité, le courant d'obscurité étant le courant généré par la photodiode même en l'absence de photons.

Par ailleurs, selon un mode de réalisation optionnel, les motifs s'étendent principalement selon une direction Dm formant avec une direction Dp (x) perpendiculaire à ladite direction principale De (z) un angle $\theta$ tel que $90 > \theta > 0$ et de préférence $80 > \theta > 10$.

Ainsi, selon ce mode de réalisation privilégié, les motifs de matériau absorbant sont inclinés. Cela permet, pour une période p donnée des motifs et pour une largeur $W_2$ donnée du coeur 210, d'avoir des motifs dont la plus grande longueur est augmentée. Avec l'invention la plus grande dimension des motifs présente ainsi une longueur L telle que $L^2 = W_2^2 + p^2$ (si la hauteur h du motif selon la direction De (z) est égale au pas p).

Avec des motifs non inclinés, cette dimension L aurait été égale à $W_2$.

Ainsi, pour une même largeur $W_2$ de coeur, l'inclinaison des motifs permet de relâcher les contraintes dimensionnelles sur la longueur des motifs, prise selon leur plus grande dimension d'extension Dm. Cela présente un avantage significatif en termes de procédé de fabrication, notamment lorsque le coeur 210 présente une largeur $W_2$ faible.

Par ailleurs, lorsque la photodiode est de type photodiode à avalanche l'invention présente pour avantage de réduire de manière significative l'excès de bruit.

Comme cela sera détaillé par la suite dans la description des figures, ce bruit est dû à la multiplication des porteurs de charges, en particulier dans le matériau absorbant habituellement fait de germanium, sous l'effet d'un champ électrique important.

De manière classique dans une photodiode, par application d'une tension, il est possible de faire se déplacer les porteurs de charges rendus libres.

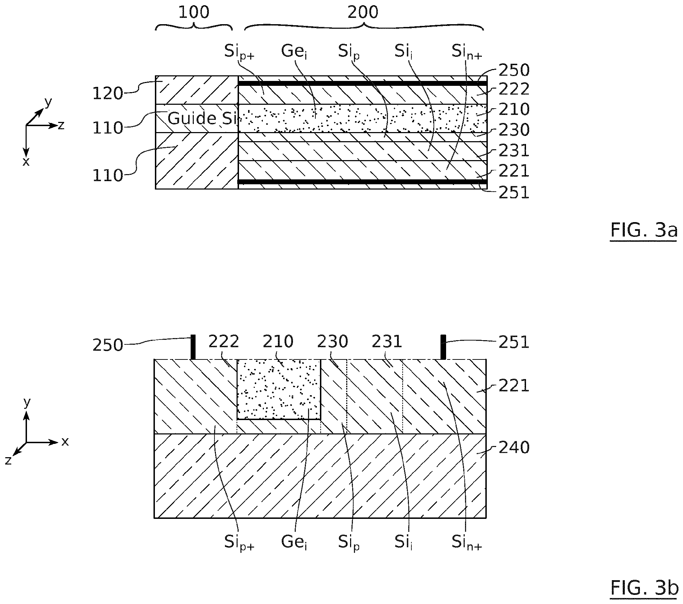

Une photodiode à avalanche conventionnelle est représentée en **figures 3a et 3b.**

Comme cela apparaît sur ces figures, la photodiode comprend des zones d'extraction 221, 222 en silicium dopé Si-n+ et Si-p+ situées de part et d'autre du coeur 210 en germanium intrinsèque (Ge-i). Les électrodes 250, 251 sont connectées aux zones d'extraction 221, 222. Par ailleurs, la photodiode comprend entre le coeur 210 et la zone d'extraction 221 en silicium dopé Si-n+, une couche de multiplication 231 en silicium intrinsèque.

En appliquant un champ électrique important, les porteurs de charge rendus libres dans le coeur 210 en Ge-i sont mis en mouvement, sont accélérés et leur énergie permet d'ioniser des atomes présents dans la couche de multiplication 231, multipliant de ce fait le nombre de porteurs de charge. Ce phénomène d'avalanche permet ainsi d'augmenter le courant généré par photon absorbé et donc d'améliorer la sensibilité de la photodiode.

Une difficulté de ce type de photodiode est que le champ électrique important a comme impact négatif de favoriser l'ionisation dans le coeur 210 en Ge-i. Une multiplication aléatoire a donc lieu dans le coeur 210 et ce caractère aléatoire est beaucoup plus important dans le germanium que dans le silicium.

Il en résulte que la multiplication dans le Ge entraîne un facteur d'excès de bruit beaucoup plus important que dans le Si.

Afin de limiter cet excès de bruit, certaines solutions de l'état de la technique prévoient une couche de charge 230 en silicium dopé p, disposée entre la zone d'extraction 221 en silicium dopé Si-n+ et la couche de multiplication 231 en silicium intrinsèque. Ce type de structure est habituellement désigné par l'acronyme SACM (Separate Absorption Charge and Multiplication, signifiant absorption et multiplication séparées des charges).

Cette structure avec couche de charge 230 permet d'appliquer un champ électrique plus faible mais suffisant pour absorber les photons et rendre libres les porteurs de charge dans le Ge-i, puis extraire ces porteurs hors du Ge-i, sans pour autant que ces porteurs soient suffisamment accélérés pour acquérir la capacité d'ioniser les atomes. On a ensuite un fort champ électrique dans la zone de multiplication 231 en Si intrinsèque adjacente à la couche de charge 230. Dans cette couche le facteur d'excès de bruit reste limité, car il s'agit de multiplication dans le Silicium.

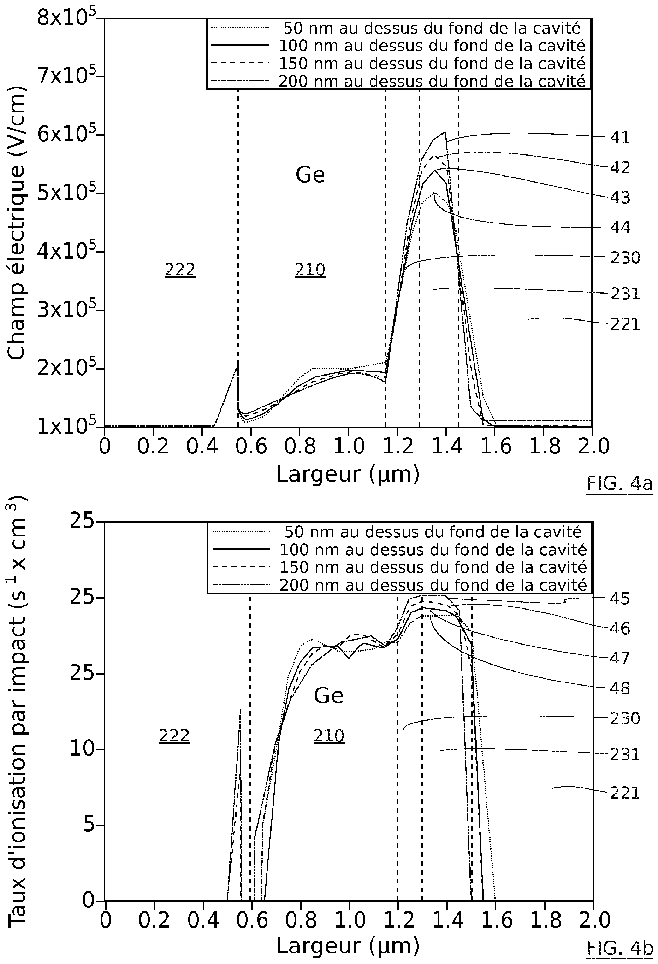

Les **figures 4a et 4b** sont des graphes illustrant respectivement le champ électrique et le taux d'ionisation par impact à l'avalanche pour différentes positions dans la photodiode selon l'art antérieur illustrée en figure 3a et 3b.

Les courbes 41 à 44 représentent chacune le champ électrique en volts par centimètres ($10^{-2}$ mètres) (V/cm) au sein de la photodiode en différentes position dans la portion d'absorption 200 selon la direction x.

La courbe 41 concerne les valeurs à 200nm ($10^{-9}$ mètres) au-dessus du fond du coeur 210, le fond étant la face du coeur 210 au regard du coeur 110 du guide d'injection.

La courbe 42 concerne les valeurs à 150nm au-dessus du fond du coeur 210. La courbe 43 concerne les valeurs à 100nm au-dessus du fond du coeur 210. La courbe 44 concerne les valeurs à 50nm au-dessus du fond du coeur 210.

Les courbes 45 à 48 représentent chacune le taux d'ionisation par impact à l'avalanche (nombre d'impact par seconde et par centimètres cubes $s^{-1}.cm^{-3}$) au sein de la photodiode en différentes position dans la portion d'absorption 200 selon la direction x.

La courbe 45 concerne les valeurs à 200nm ($10^{-9}$ mètres) au-dessus du fond du coeur 210. La courbe 46 concerne les valeurs à 150nm au-dessus du fond du coeur 210. La courbe 47 concerne les valeurs à 100nm au-dessus du fond du coeur 210. La courbe 48 concerne les valeurs à 50nm au-dessus du fond du coeur 210.

Comme cela apparaît sur ces graphes, on observe que même si le champ électrique est faible dans le coeur 210 en Ge-i, le taux d'ionisation par impact à l'avalanche dans le coeur 210 en Ge-i et donc la multiplication aléatoire des porteurs reste importante. Pour les photodiodes à avalanches, le facteur d'excès de bruit reste donc significatif en dépit de ces structures de type SACM.

Par ailleurs, ces structures de type SACM reposent sur une réduction de la vitesse d'extraction des porteurs de charge dans le germanium. Cela conduit de manière inévitable et préjudiciable à une réduction de la bande passante.

Il serait donc très avantageux de proposer une solution pour augmenter la largeur de la bande passante des photodiodes à avalanche sans augmenter, voire en diminuant le facteur d'excès de bruit.

Or l'invention, en prévoyant d'incliner les motifs formés du matériau absorbant, permet d'assurer que les porteurs rendus libres par absorption de photons, une fois entraînés en déplacement et accélérés par le champ électrique, ne seront accélérés que sur une courte distance de Ge.

En effet, les porteurs se déplacent parallèlement à la direction du champ électrique, c'est-à-dire perpendiculairement à l'axe de propagation de la lumière qui correspond à la direction « De » d'extension du coeur de la photodiode. Les porteurs de charge, contrairement aux photons, ne traversent donc que très peu de Ge puisque les motifs de Ge sont inclinés et présentent donc une largeur faible selon la direction de déplacement des porteurs de charge. On peut ainsi accélérer plus fortement les porteurs sans augmenter le facteur d'excès de bruit dans le Ge, et améliorer ainsi la bande passante. On rappellera que le facteur d'excès de bruit est dû essentiellement à la multiplication dans le Ge et nettement moins à la multiplication dans la gaine, faite typiquement de Silicium.

Cette réduction de l'excès de bruit est tellement significative que la couche de charge, habituellement disposée au contact du coeur en Ge peut être supprimée dans une photodiode à avalanche munie d'un coeur structuré tel que le prévoit la présente invention.

On notera que ces avantages liés à la réduction du facteur d'excès de bruit et à l'élargissement de la bande passante par rapport aux structures SACM, reposent sur l'inclinaison des motifs du matériau absorbant. Pour obtenir ces avantages, il n'est pas indispensable que les motifs soient disposés selon un pas spécifique.

Selon un mode de réalisation, l'invention porte sur une photodiode, de préférence à double hétérojonction, comprenant au moins une portion d'absorption, la portion d'absorption comportant au moins un coeur de préférence entouré au moins en partie d'une gaine comprenant au moins deux zones d'extraction de charges, le coeur comprenant :

- une pluralité de motifs formés d'un premier matériau ayant la propriété de générer le déplacement de porteurs de charges électriques à partir de photons se propageant dans ledit premier matériau;
- une couche de confinement à l'intérieur de laquelle sont situés les motifs, la couche de confinement étant formée d'un deuxième matériau différent du premier et apte à être rendu électriquement conducteur.

Par ailleurs, les motifs s'étendent principalement selon une direction Dm formant avec une direction Dp (x) perpendiculaire à ladite direction principale De (z) un angle θ tel que 90>θ>0 et de préférence 80>θ>10.

Avec cette configuration des motifs, les porteurs générés par absorption, une fois accélérés par le champ électrique, ne seront accélérés que sur une courte distance du matériau absorbant, typiquement du germanium. L'invention permet ainsi une réduction très significative de l'excès de bruit.

Elle permet alors de conserver un champ électrique important dans le coeur et donc d'accélérer la vitesse d'extraction des porteurs de charge. La bande passante d'une photodiode à avalanche selon l'invention est donc plus importante qu'une photodiode à avalanche de type SACM dans laquelle le champ électrique dans le Ge est réduit.

Par ailleurs ce mode de réalisation spécifique aux photodiodes à avalanche présente les mêmes avantages que ceux mentionnés pour les modes de réalisation précédents à savoir : une longueur de portion d'absorption réduite, une bande passante plus large et un courant d'obscurité diminué.

Un autre objet de la présente invention concerne un dispositif microélectronique comprenant au moins et de préférence une pluralité de photodiodes selon l'un des modes de réalisation mentionnés ci-dessus.

Par dispositif microélectronique, on entend tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La **figure 1** est une vue en coupe schématisée d'une photodiode à double hétérojonction Si-p/Ge-i/Si-n selon l'art antérieur, sur laquelle une simulation de la propagation des ondes lumineuses est représentée de manière schématique.

Les **figures 2a et 2b** sont des vues d'une photodiode à double hétérojonction proche de celle de la figure 1, selon des coupes transversales (xy) prises respectivement au niveau de la portion d'absorption et du guide d'injection.

La **figure 2c** est une vue schématisée de la photodiode des figures 2a et 2b selon une coupe longitudinale (zx), c'est-à-dire parallèle à la direction principale de propagation des ondes lumineuses.

Les **figures 3a et 3b** sont des vues en coupe, respectivement selon une coupe longitudinale (zx) et selon une coupe transversale (xy), d'une photodiode à avalanche selon l'état de la technique.

Les **figures 4a et 4b** sont des graphes illustrant respectivement le champ électrique et le taux d'ionisation par impact à l'avalanche pour différentes positions dans la photodiode à avalanche illustrée en figures 3a et 3b.

La **figure 5a** est une vue en coupe longitudinale (zx) illustrant de manière schématique une photodiode selon un premier mode de réalisation non limitatif de la présente invention.

La **figure 5b** est une vue agrandie de la figure 5a, centrée sur deux des motifs du matériau absorbant.

La **figure 6a** est une vue en coupe longitudinale (zx) illustrant de manière schématique une photodiode selon un deuxième mode de réalisation non limitatif de la présente invention, dans ce deuxième mode de réalisation, la photodiode est de type photodiode à avalanche.

La **figure 6b** est une vue agrandie de la figure 6a, centrée sur l'un des motifs du matériau absorbant.

Les **figures 7a et 7b** sont des simulations selon la méthode des différences finies dans le domaine temporel (FDTD) de la diffusion de la lumière dans le coeur de la portion d'absorption, pour une photodiode selon l'art antérieur. La figure 7a représente toute la longueur de la portion d'absorption. La figure 7b est un agrandissement de la figure 7a, pris au niveau de l'interface entre le guide d'injection et l'extrémité amont de la portion d'absorption.

Les **figures 8a et 8b** sont des simulations identiques à celles des figures 7a et 7b respectivement, pour une photodiode selon un exemple de réalisation de la présente invention.

Les **figures 9a et 9b** illustrent l'évolution de l'absorption de la photodiode en fonction de la longueur (selon l'axe z) de la portion d'absorption pour respectivement une photodiode selon l'art antérieur et une photodiode selon un exemple de réalisation de la présente invention.

Les **figures 10a et 10b** illustrent des exemples de modes de réalisation alternatifs à celui des figures 5a à 6b.

La **figure 11, comprenant les figures 11a à 11g,** illustre les étapes principales d'un exemple de procédé de réalisation d'une photodiode selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches ainsi que les dimensions relatives des différentes portions de photodiode et des motifs ne sont pas représentatives de la réalité.

DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement.

- Selon un exemple de réalisation, le pas p est suffisamment faible pour que la propagation du flux lumineux s'effectue principalement le long de la direction De (z) et selon un phénomène de lumière lente.

- Selon un exemple de réalisation, le pas p est tel que :

$$p \leq \frac{\lambda}{4}$$

λ étant la longueur d'onde à détecter par la photodiode, de préférence la plus petite longueur d'onde à détecter par la photodiode.

- Selon un exemple de réalisation, le pas p est tel que :

$$p \leq \frac{\lambda}{6}$$ et de préférence $$p \leq \frac{\lambda}{7}.$$

- Selon un exemple de réalisation, l'angle θ est tel que 70>θ>5 et de préférence 60>θ>10 et de préférence 50>θ>15. Selon un exemple de réalisation, l'angle θ est tel que 70>θ. Selon un exemple de réalisation l'angle θ est tel que θ>10.

- Selon un exemple de réalisation, les motifs sont disposés de manière périodique selon une direction principale De (z) d'extension dudit coeur en présentant un pas p tel que :

$$p < \frac{\lambda}{2 \, n_{eff}}$$

$n_{eff}$ étant l'indice de réfraction effectif du mode.

L'homme du métier sait déterminer $n_{eff}$. De manière conventionnelle il pourra par exemple utiliser un outil de simulation pour déterminer $n_{eff}$. A titre d'exemple non limitatif, il pourra utiliser un logiciel de type solveur de modes par éléments finis (par exemple logiciel Comsol développé par la société Comsol).

Avec ce pas p, la photodiode selon l'invention permet une propagation de la lumière selon un phénomène de lumière lente. Pour une sensibilité donnée, cela permet de réduire encore plus la longueur de la photodiode et donc d'augmenter encore plus la bande passante de la photodiode.

- Selon un exemple de réalisation, $n_{eff}$ >2, de préférence $n_{eff}$ >1.8, de préférence $n_{eff}$ >1.5.

- Selon un exemple de réalisation, la photodiode est configurée de manière à ce qu'une lumière incidente à détecter parvienne au coeur selon ladite direction principale De (z). C'est cette lumière incidente qui fournit les photons destinés à être absorbés dans le premier matériau.

- Selon un exemple de réalisation, la photodiode est configurée de manière à ce qu'une lumière à détecter se propage au sein de la photodiode principalement selon ladite direction principale De (z).

- Selon un exemple de réalisation, la photodiode est configurée de manière à recevoir une lumière incidente. La direction principale de la lumière incidente au niveau de la portion d'absorption est parallèle à ladite direction principale De (z) et de préférence correspond à ladite direction principale De (z). Ainsi la lumière incidente arrive sur la portion d'absorption, de préférence parvient sur le coeur, selon la direction direction De (z), la direction principale De (z) étant la direction selon laquelle les motifs sont disposés de manière périodique

- Selon un exemple de réalisation, les motifs du coeur sont formés d'un matériau semi-conducteur intrinsèque tel que le germanium (Ge) et la couche de confinement est en silicium et lesdites zones d'extraction sont en silicium (Si) dopé p et n.

- Selon un exemple de réalisation, les motifs sont disposés de manière périodique selon une direction principale De (z) d'extension dudit coeur en présentant un pas p tel que p≤425 nm ($10^{-9}$ mètres), de préférence p≤400 nm, de préférence p≤330 nm, de préférence p≤280 nm, de préférence p≤250 nm. Avec ces valeurs, on réduit considérablement la diffraction dans la gaine et l'on absorbe la lumière sur une longueur réduite de portion d'absorption, voire on supprime la diffraction et l'on obtient un phénomène de lumière lente.

- Selon un exemple de réalisation, À, la longueur d'onde à détecter par la photodiode, de préférence la plus petite longueur d'onde à détecter par la photodiode est telle que λ≤2 μm ($10^{-6}$ mètres). De préférence λ≤1.7 μm. De préférence λ≥1.0 μm.

- Selon un exemple de réalisation, 1.0≤λ≤1.7 μm. De préférence 1.0≤λ≤1.55 μm. De préférence 1.1≤λ≤1.55 μm. De préférence 1.31≤λ≤1.7 μm. De préférence 1.31≤λ≤1.55 μm.

  - Selon un exemple de réalisation, la photodiode forme une photodiode à avalanche.

  - Selon un exemple de réalisation, le déplacement de porteurs de charges électriques dans le coeur s'effectue selon des directions parallèles à la direction Dp (x) et la hauteur h des motifs, prise selon la direction principale De(z) est telle que 3p≥h≥0.5p et de préférence 2p≥h≥0.5p et de préférence 1.5p≥h≥0.5p et de préférence 1.2≥h≥0.8p.

Avec p≥h ; les motifs, projetés selon la direction De (z), ne se chevauchent pas et la photodiode est configurée de manière à ce que le déplacement de porteurs de charges électriques dans le coeur s'effectue selon des directions parallèles à la direction Dp (x). Ainsi, les porteurs de charges, en parcourant des directions parallèles à la direction Dp (x), ne rencontrent chacun qu'un seul motif au cours de leur déplacement dans le coeur.

Lorsque la photodiode est de type photodiode à avalanche, cela permet de réduire de manière significative l'excès de bruit dû aux multiplications aléatoires dans le matériau absorbant, par exemple le germanium.

En effet, avec cette configuration des motifs, les porteurs rendus libres par absorption, une fois accélérés par le champ électrique, ne seront accélérés que sur une courte distance du matériau absorbant.

Les porteurs de charge, contrairement aux photons, ne traversent donc que très peu de Ge. Or le facteur d'excès de bruit est dû essentiellement à la multiplication dans le Ge et nettement moins à la multiplication dans la gaine, faite de Silicium.

L'invention permet ainsi une réduction très significative de l'excès de bruit.

Selon un exemple de réalisation, la hauteur h des motifs, prise selon la direction principale De(z) est sensiblement égale au pas p des motifs (h=p). Les motifs projetés selon la direction De (z), sont donc juxtaposés. Ainsi, les motifs projetés selon la direction De (z), ne laissent pas d'espace intermédiaire entre eux. Ainsi, en parcourant des directions parallèles à la direction Dp (x), on rencontre inévitablement un, et de préférence un seul motif et la quantité de matériau absorbant est augmentée pour une longueur donnée de photodiode.

$$\theta \leq \tan^{-1}(\frac{P}{W_2}),$$

- Selon un exemple de réalisation, $W_2$ étant la largeur du coeur ou la largeur prise selon la direction Dp (x) dans laquelle le motif doit rentrer

$$\theta \approx \tan^{-1}(\frac{P}{W_2}).$$

et de préférence

Cela permet d'augmenter la quantité de matériau absorbant sans rallonger la longueur de la portion d'absorption.

- Selon un exemple de réalisation, la photodiode comprend une couche de multiplication configurée pour favoriser la multiplication de porteurs de charge par impact, la couche de multiplication étant disposée entre l'une des zones d'extraction et le coeur. De préférence la couche de multiplication est en silicium intrinsèque.

Selon un exemple de réalisation, la couche de multiplication est directement au contact du coeur et de l'une des zones d'extraction. Ainsi la photodiode ne comprend pas de couche de charge. Cela est rendu possible par le fait que, par rapport aux solutions connues, l'invention permet de réduire significativement l'excès de bruit habituellement causé par la multiplication aléatoire des porteurs de charge dans le germanium.

Alternativement, la photodiode comprend une couche de charge disposée entre la couche de multiplication et le coeur. Ainsi, la couche de multiplication n'est pas au contact du coeur. On applique un champ électrique dans le coeur de manière à ce que les multiplications s'effectuent hors du coeur ou au moins essentiellement hors du coeur de la portion d'absorption. De préférence la couche de charge est en silicium dopé p.

- Selon un exemple de réalisation, le deuxième matériau formant la couche de confinement est à base du même matériau qu'un matériau formant les zones d'extraction de charges.

De préférence le deuxième matériau est identique au matériau des zones d'extraction de charges. Cela permet de simplifier la réalisation de la photodiode.

La couche de confinement est électriquement conductrice ou apte à être rendue électriquement conductrice. Elle peut être en matériau conducteur ou semi-conducteur.

- Selon un exemple de réalisation, la largeur des motifs est égale à la largeur $W_2$ du coeur de la portion d'absorption, la largeur des motifs étant mesurée en projection selon la direction Dp (x) et prise d'une extrémité à l'autre du motif.
- Les motifs présentent des flancs, de préférence sensiblement parallèles, qui s'étendent principalement selon la direction Dm.
- Selon un exemple de réalisation, le coeur de la portion d'absorption présente une largeur $W_2$ mesurée en projection selon la direction Dp (x). Les motifs présentent des flancs sensiblement parallèles à ladite direction Dm. Les motifs présentent une dimension $W_{21}$ prise, d'un flanc à l'autre et selon la direction Dp (x) perpendiculaire à ladite direction principale De (z), avec $W_{21} \leq W_2/k$, et avec $k \geq 1.5$, de préférence $k \geq 2$, de préférence $k \geq 3$, de préférence $k \geq 4$.
- Selon un exemple de réalisation, les motifs présentent des flancs sensiblement parallèles à ladite direction Dm. Les motifs présentent une dimension $W_{21}$ prise, d'un flanc à l'autre et selon la direction Dp (x) perpendiculaire à ladite direction principale De (z), avec $W_{21} \leq p/m$, et avec $m \geq 1$, de préférence $m \geq 1.5$.
- Selon un exemple de réalisation, $W_2 \geq p$.

De manière également facultative, l'invention pourra présenter au moins l'une quelconque des revendications suivantes qui pourront être prises en association ou alternativement.

- Selon un exemple de réalisation, au moins l'une parmi la gaine du guide d'injection et la gaine de la portion d'absorption comprend de l'air, un gaz ou du vide.
- Selon un exemple de réalisation, la différence entre les indices de réfraction du coeur et de la gaine du guide d'injection est supérieure à la différence entre les indices de réfraction du coeur et de la gaine de la portion d'absorption. Cela permet de mieux confiner la lumière dans le coeur en évitant sa diffusion dans la gaine du guide d'absorption.

- Selon un exemple de réalisation, la photodiode est de type Si-n/Ge-i/Si-p.

- Selon un exemple de réalisation, au moins l'un et de préférence les deux parmi le coeur du guide d'injection et le coeur de la portion d'absorption présente, en section selon un plan xy parallèle audit plan transverse zx, une surface inférieure à $100\mu m^2$, de préférence inférieure à $10\mu m^2$, et de préférence inférieure à $1\mu m^2$. Typiquement le diamètre, si la section du coeur est circulaire, ou le plus grand côté si la section du coeur est un polygone, est inférieur à 50 $\mu m$, de préférence inférieur à 10 $\mu m$ et de préférence inférieur à 1 $\mu m$.

- Selon un exemple de réalisation, les coeurs des premier et deuxième guides sont en contact direct. C'est-à-dire qu'il n'y a pas d'élément, de vide ou d'air entre eux.

- Selon un exemple de réalisation, les premier et deuxième coeurs forment une interface de couplage, ladite interface étant plane. Selon un exemple de réalisation, l'interface est contenue dans un plan (xy) parallèle audit plan transverse (zx).

- Selon un exemple de réalisation, la photodiode comprend un guide d'injection comprenant un coeur et une gaine, le coeur du guide d'injection étant configuré pour apporter des ondes lumineuses au coeur de la portion d'absorption.

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par au moins une autre couche ou au moins un autre élément.

De manière conventionnelle, un dopage noté p signifie qu'il s'agit d'un dopage par des charges positives et un dopage n signifie qu'il s'agit d'un dopage par des charges négatives.

On notera dans que dans la suite de la description la bande passante de la photodiode s'exprime en Hz ou Giga Hz et caractérise sa rapidité de réaction et non pas la gamme de longueurs d'ondes qu'elle peut détecter.

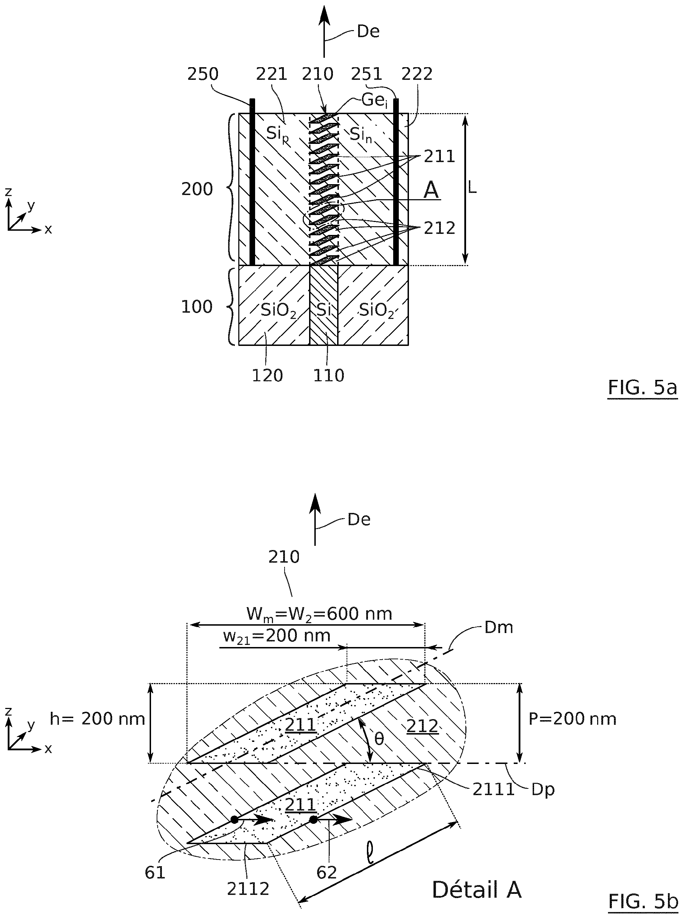

Un exemple de photodiode selon l'invention va maintenant être décrit en référence aux **figures 5a et 5b.**

La photodiode selon l'invention comprend au moins un premier guide d'ondes formant un guide d'injection 100 et un deuxième guide d'ondes formant la portion 200 d'absorption et d'extraction des charges. Chaque guide d'ondes comprend un coeur 110, 210 et une gaine 120, 220. La lumière pénètre dans le guide d'injection 100 pour ensuite parvenir dans le coeur 210 de la portion 200 d'absorption et d'extraction.

Le coeur 210 comprend un matériau ayant la propriété d'absorber des photons avec pour conséquence de rendre libre des porteurs de charges électriques qu'il contient. On parle généralement de matériaux à gap. Sous l'effet d'un champ électrique, ces porteurs de charges rendus libres sont ensuite mis en mouvement pour être collectés et extraits au niveau des zones d'extraction 221, 222 de la gaine 220. On prévoit également des électrodes 250, 251 au niveau des zones d'extraction 221, 222.

De manière générale, les zones d'extraction 221, 222 sont en matériau électriquement conducteur ou apte à être rendu conducteur. Il s'agit le plus souvent d'un matériau semi-conducteur tel que du silicium (Si) dopé p et n pour respectivement zones d'extraction 221, 222. La gaine 220 peut en outre comprendre une couche additionnelle 223 recouvrant le coeur 210, et les zones d'extraction 221, 222, comme cela est le cas pour la photodiode illustrée en figure 2a. Cette couche d'encapsulation est de préférence formée d'un diélectrique tel que le $SiO_2$.

Comme illustré en figure 5a, les coeurs 110, 210 des guides 100, 200 présentent des sections, prise selon une coupe xy qui reste sensiblement constante le long de l'axe z.

Le repère normé x, y, z est indiqué en figure 5a. L'axe z correspond à une direction principale d'extension De du coeur 110, 210 des guides 100, 200. C'est parallèlement à cette direction principale De que le flux lumineux se propage principalement dans les guides 100, 200.

Dans l'exemple illustré, et sans que cela soit limitatif, le coeur 110 du guide d'injection 100 est en Si, sa gaine 120 est en $SiO_2$, les motifs 211 du coeur 210 du guide d'absorption 200 sont en Ge-i et sa couche de confinement 212 en Si. La gaine 220 du guide d'absorption 200 est formée d'une zone 221 de Si dopé n (Si-n) et d'une zone 222 de Si dopé p (Si-p).

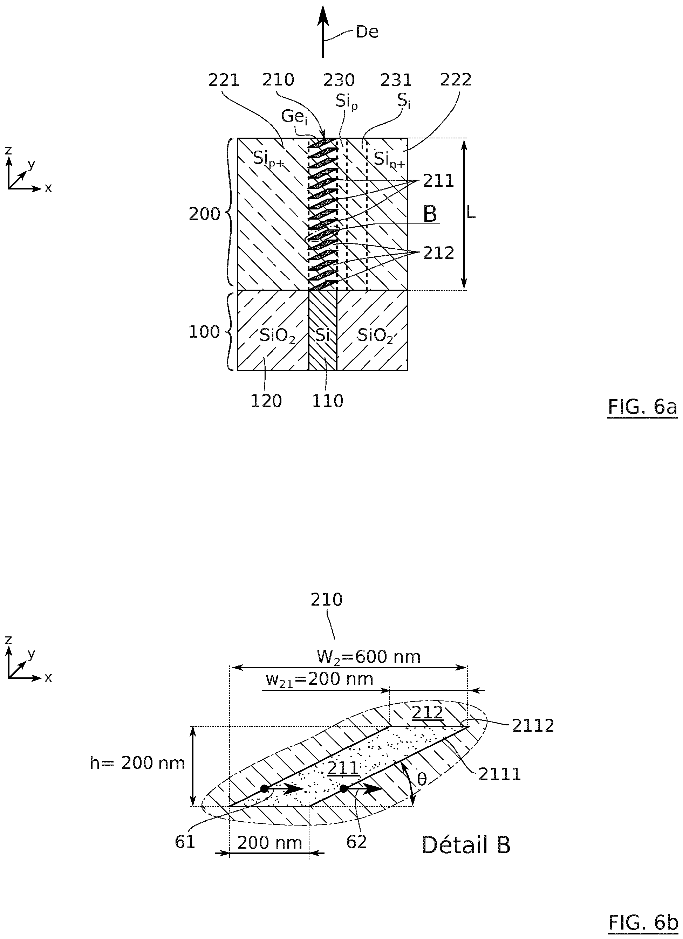

Ainsi, les motifs 211 du coeur sont en germanium et sont entourés de silicium. Ce type de photodiode définit donc, pour chaque motif 211, deux interfaces Si/Ge, par exemple en parcourant la direction Dp (x), qui correspond sensiblement à la direction de déplacement des porteurs de charge électriques. Cela apparait clairement sur les figures 5a et 6a. Cette photodiode définit donc, pour chaque motif 211, deux hétérojonctions. Elle peut ainsi être qualifiée de photodiode à double hétérojonction.

On rappellera que dans la littérature une photodiode à double hétérojonction qualifie une photodiode dont le coeur définit une première et une deuxième jonctions Si/Ge.

Avantageusement, pour chaque guide d'ondes, l'indice de réfraction du coeur est supérieur à l'indice de réfraction de sa gaine afin de confiner le rayon lumineux dans les coeurs 110, 210 en évitant une diffusion au sein des gaines 120, 220. On notera que l'homme du métier sait calculer l'indice de réfraction d'une gaine si cette dernière est hétérogène à la surface du coeur.

L'homme du métier sait également calculer l'indice de réfraction du coeur 210 hétérogène.

On notera que l'effet des motifs 211 sur le faisceau est principalement contenu selon l'axe x. Ainsi la portion de gaine 220 à prendre en compte en termes d'indices de réfraction est principalement la gaine latérale, formée dans cet exemple non limitatif par les zones 221, 222 et le cas échéant 230, 231.

De manière avantageuse, le coeur 210 du guide d'absorption 200 comprend une pluralité de motifs 211 formés du matériau absorbant.

Ainsi, ce dernier n'est pas réparti de manière homogène sur toute la longueur L de la portion d'absorption de la photodiode. Il est distribué de manière ponctuelle. Les motifs 211 forment ainsi des inclusions.

Le coeur 210 comprend également une couche de confinement 212 à l'intérieur de laquelle les motifs 211 forment des inclusions. La couche de confinement 212 est faite d'un matériau apte à être rendu électriquement conducteur tel qu'un matériau semi-conducteur ou un matériau conducteur.

Les motifs 211 sont répartis selon la direction De (z) avec un pas p qui contribue à générer de multiples réflexions pour les photons en limitant la diffraction dans la gaine 210. Ces multiples réflexions génèrent un phénomène de ralentissement de la lumière ce qui fait que plus de photons sont absorbés sur une longueur donnée. Par rapport aux photodiodes selon l'art antérieur, on peut ainsi réduire la longueur du guide d'absorption 200 pour une sensibilité donnée.

Selon un mode de réalisation avantageux, le pas p des motifs 211 est tel que :

$$(1) \qquad p \leq \frac{\lambda}{4}$$

λ étant la longueur d'onde la plus courte que la photodiode est censée détecter.

Pour une application aux télécommunications, λ est par exemple compris entre 0,8 x 1,55 μm et 1,2 x 1,55 μm et de préférence égale à 1,55 μm.

De préférence, $p \leq \frac{\lambda}{6}$ et de préférence $p \leq \frac{\lambda}{7}$.

Avec la condition (1), la diffraction de la lumière dans la gaine 220 est réduite, voire supprimée, et l'absorption dans le coeur 210 sur une distance donnée est améliorée.

Selon un mode de réalisation encore plus avantageux, le pas p de la segmentation est tel que :

$$(2) \qquad p \leq \frac{\lambda}{2n_{eff}}$$

$n_{eff}$ étant l'indice effectif du mode. Cet indice se détermine par des méthodes et outils bien connus de l'homme du métier. Par exemple, il pourra utiliser un logiciel de type solveur de modes par éléments finis (par exemple logiciel Comsol développé par la société Comsol). De préférence $n_{eff}$ >2. De préférence $n_{eff}$ >1.8 et de préférence $n_{eff}$ >1.5.

Pour une photodiode dont les motifs 211 sont en Germanium intrinsèque (Ge-i), la couche de confinement 212 est par exemple en silicium et les zones d'extraction 221, 222 sont en Si-p et Si-n , l'équation (2) revient à :

$$p < \frac{\lambda}{7}.$$

Avec λ = 1,55 μm, le pas p doit alors être inférieur à 200 nm.

Si la condition (2) est respectée, on obtient un phénomène de lumière lente, la lumière ralentissant dans le coeur 210 pour y être absorbée sur une distance courte, ceci sans ou avec très peu de diffraction dans la gaine. Avec la condition (2), la lumière se propage dans le coeur structuré et hétérogène en accomplissant localement des réflexions multiples mais en avançant globalement comme dans un milieu homogène.

Avec la condition (2), on obtient une réduction des pertes par rugosité due à une délocalisation du mode par réduction de l'indice effectif.

La condition (2) permet donc de réduire encore plus fortement la longueur du coeur 210 pour une sensibilité donnée de photodiode. La bande passante est donc augmentée sans dégrader la sensibilité.

Avantageusement, p≤425 nm (10$^{-9}$ mètres), de préférence p≤400 nm, de préférence p≤330 nm, de préférence p≤280 nm, de préférence p≤250 nm.

Ce pas p permet des performances particulièrement bonnes dans le domaine des télécommunications où les longueurs d'ondes sont généralement inférieures à 2μm et de préférence inférieures à 1.7μm et avec des photodiodes dont le coeur 110 du guide d'injection 100 est à base de germanium et dont le coeur 210 de la portion d'absorption 200 est à base de germanium.

On réduit considérablement la diffraction dans la gaine et l'on absorbe la lumière sur une longueur réduite de portion d'absorption, voire on supprime la diffraction et l'on obtient un phénomène de lumière lente.

La figure 5b illustre deux motifs agrandis. Sur cette figure sont illustrés :

- la direction De d'extension principale du coeur 210 qui est parallèle à l'axe z ;

- la direction Dm correspondant à la direction principale selon laquelle les motifs 211 s'étendent.
- la direction Dp perpendiculaire à la direction De et parallèle à l'axe x.
- le pas p : ce pas p est mesuré selon la direction De (z), par exemple d'une extrémité supérieure d'un motif 211 à l'extrémité supérieure du motif 211 qui lui est adjacent.
- la longueur L du guide d'absorption 200. Cette longueur, prise selon la direction De (z) est de préférence sensiblement égale à la longueur du coeur 210.
- la largeur $W_m$ du motif 211 : cette largeur $W_m$ est prise selon la direction Dp (x) d'une extrémité à l'autre du motif 211.

De manière non limitative mais préférée, la largeur $W_m$ du motif correspond à la largeur $W_2$ du coeur 210.

- la hauteur h du motif 211 : cette hauteur h est prise selon la direction De (z) et mesurée d'une extrémité 2112 à l'autre 2112 du motif 211.
- la longueur l du motif 211 : cette longueur l étant prise selon la direction Dm et mesurée d'une extrémité 2112 à l'autre 2112 du motif 211 selon cette direction.

Sur l'exemple non limitatif de la figure 5a, le motif 211 étant un parallélogramme, il présente des flancs 2111 parallèles orientés selon la direction Dm et qui correspondent à sa longueur l. Ces flancs 2111 joignent les deux extrémités 2112 du motif 211.

Comme illustré aux figures 5a et 5b les motifs 211 sont inclinés. Ils s'étendent selon la direction principale Dm qui forme avec la direction Dp un angle θ avec θ>0, de préférence, θ<90.

L'inclinaison des motifs présente plusieurs avantages.

Il permet, pour une largeur $W_2$ de coeur 210 donnée, de réaliser des motifs 211 dont la longueur l est plus importante. Cela permet de relâcher les contraintes de fabrication pour cette dimension, ce qui s'avère particulièrement avantageux lorsque le coeur 210 est très fin (faible dimension selon Dp (x)).

Par ailleurs, l'inclinaison des motifs 211 apporte un avantage considérable lorsque la photodiode doit être le siège de multiplication de porteurs créés dans le matériau absorbant, comme cela est le cas dans les photodiodes à avalanche, telles que celles illustrées en figure 6a et dans laquelle on retrouve les éléments de la figure 3a en y ajoutant le coeur 210 segmenté.

Plus précisément et comme expliqué en section « Résumé », l'inclinaison des motifs 211 du coeur structuré permet de limiter la distance parcourue par les porteurs de charge dans le matériau absorbant typiquement du germanium. En effet, les porteurs se déplacent selon la direction Dp (x) perpendiculaire à la direction De (z) des photons.

Ils traversent donc au maximum une distance $W_{21}$ de matériau absorbant (comme illustré par la référence 61 en figure 6b) et au minimum seulement quelques nanomètres, voire moins, de ce matériau comme illustré par la référence 62 en figure 6b).

Comme illustré en figures 6a, 6b, les porteurs de charges traversent au maximum une distance $W_{21}$ de matériau absorbant, c'est-à-dire dans cet exemple 200 nm, alors que la largeur $W_2$ du coeur 210 est de 600 μm. En revanche la distance parcourue par les photons est supérieure puisque ces derniers peuvent possiblement traverser plusieurs motifs 211 selon la direction De (z).

Ainsi, les porteurs rendus libres par absorption ne sont accélérés que sur une courte distance dans le matériau absorbant. Or c'est dans ce matériau que la multiplication s'effectue de manière particulièrement aléatoire, générant un excès de bruit qu'il n'est pas possible de calibrer.

L'invention permet ainsi de réduire l'excès de bruit.

Selon une première approche, il est donc possible d'augmenter significativement le champ électrique dans le matériau absorbant puisque peu de multiplications s'effectueront. On peut donc réduire le temps de transit des porteurs de charge ce qui améliore la bande passante.

On peut trouver une tension de polarisation pour que les porteurs ne soient multipliés que dans la couche de multiplication 231 et dès qu'ils franchissent l'interface entre matériau absorbant et matériau de multiplication (typiquement l'interface Ge/Si) et ceci sans utiliser de couche de charge 230 telle que celle illustrée en figures 6a et 12.

Selon une autre approche, si au contraire on utilise une couche de charge 230 comme illustré en figure 6a, cette dernière permet de mieux contrôler le champ électrique dans les inclusions du matériau absorbant. Il est alors possible d'augmenter la tension de polarisation et donc le gain, tout en limitant très fortement l'excès de bruit, si l'on veille à ne pas dépasser le seuil de multiplication dans le matériau absorbant.

Selon un mode de réalisation, la hauteur h du motif 211 est inférieure ou égale au pas p.

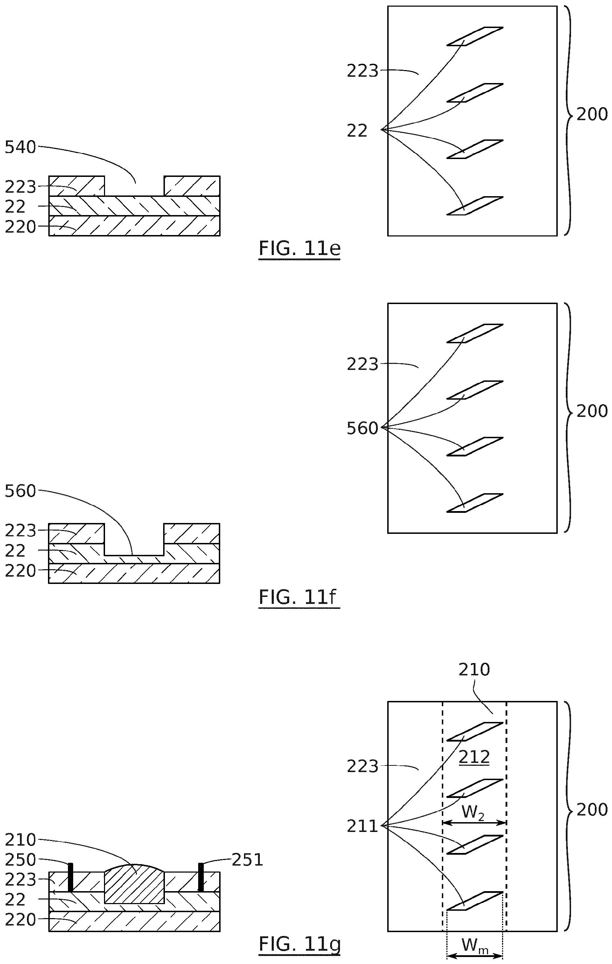

Si h<p, alors en projection sur la direction De (z), deux motifs 211 adjacents sont séparés par du matériau formant la couche de confinement 212 par une distance d. Cette configuration est illustrée par les motifs 211 en traits pleins sur la figure 11e qui sera décrite par la suite.

Si h=p, alors en projection sur la direction De (z), deux motifs adjacents sont bout à bout (d=0).

Ce mode de réalisation présente pour avantage de réduire la longueur L de la photodiode en augmentant la quantité de matériau absorbant que peuvent traverser les photons.

L'angle θ formé par la direction Dm d'inclinaison du motif 211 et par la direction transversale Dp satisfait de préférence la condition suivante :

$$\theta \leq \tan^{-1}\left(\frac{P}{w_2}\right)$$

$W_2$ étant la largeur du coeur 210 prise selon la direction Dp (x), ou la largeur, selon la direction Dp (x), dans laquelle le motif 211 doit être contenu. De préférence :

$$\theta \approx \tan^{-1}\left(\frac{P}{w_2}\right)$$

Avec cette condition, pour une largeur donnée $W_2$ du coeur 210 et un pas p donné, on peut ainsi augmenter la dimension l du motif 211, c'est-à-dire sa dimension selon la direction Dm.

Avec les dimensions suivantes $W_2$=600 $\mu$m et p=200 $\mu$m, alors $\theta \leq 18°$ et de préférence $\theta \approx 18°$.

Cette condition définit ainsi la longueur l maximale du motif 211.

Selon un autre mode de réalisation illustré en figure 11e par les motifs 211' en pointillés, la projection sur la direction De (z) des motifs 211, 211' se chevauchent. Ainsi, la distance d'est « négative ».

Ce mode de réalisation a pour avantage de densifier les motifs 211 pour une longueur L donnée de coeur 210 et donc d'augmenter la quantité de matériau absorbant.

En revanche, certains porteurs de charge traverseront deux motifs 211 selon la direction Dp(x) ce qui n'est pas optimal pour les photodiodes à avalanche pour les raisons évoquées ci-dessus concernant la réduction du facteur d'excès de bruit.

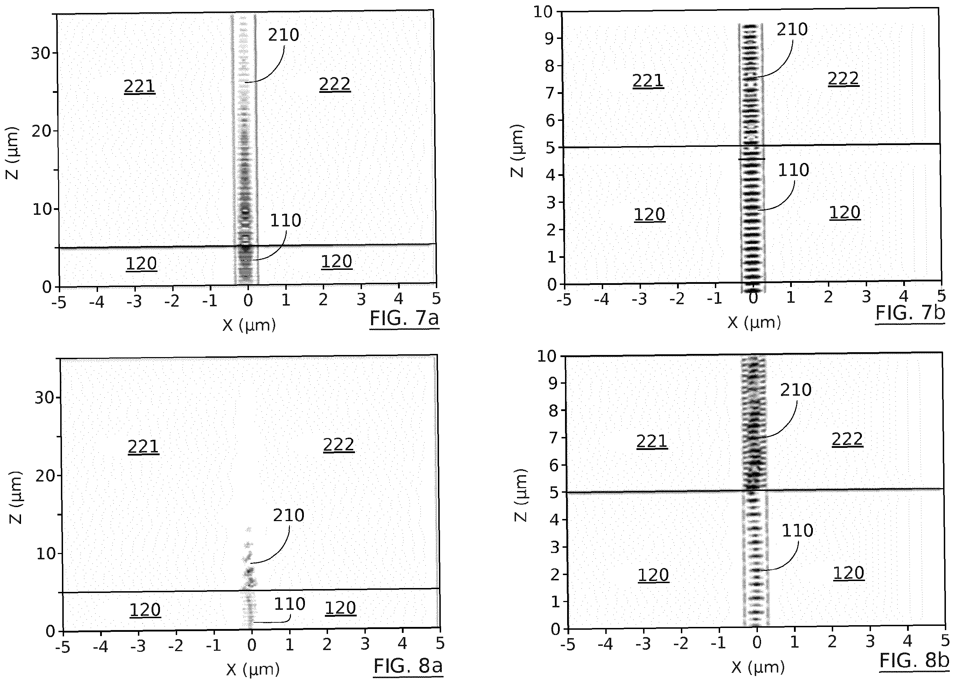

En référence aux figures 7a à 9b, les performances d'un exemple de photodiode selon l'exemple de réalisation de l'invention illustré en figures 5a, 5b vont être comparées aux performances d'une photodiode classique telle qu'illustrée aux figures 2a à 2c.

Dans ces simulations :

$\lambda$ = 1,55$\mu$m
$W_2$ = 600nm (Largeur du coeur 210 pour les photodiodes classiques et selon l'invention)
p = 200 nm
$N_{21}$ = 200 nm
$\theta$ = 18°

Les matériaux étant ceux illustrés sur les figures 5a et 6a.

Guide d'injection 100

- coeur 110 : Si
- gaine 120 : SiO$_2$

Guide d'absorption 200

- zones d'extraction 221, 222 : Si-p et Si-n
- coeur 210 : Ge-i pour la photodiode classique
- Motif 211' en Ge-i et couche de confinement 212 en Si pour la photodiode selon l'invention.

Les figures 7a et 8a sont des simulations, obtenues selon la méthode FDTD, de l'absorption selon la direction De(z) vue dans le plan en coupe (zx) pour respectivement une photodiode classique et la photodiode de la figure 5a.

Les figures 7b et 8b sont des vues agrandies au niveau de l'interface entre le guide d'injection 100 et le guide d'absorption 200.

Sur les figures 7a et 7b, on observe qu'avec la photodiode standard, l'absorption s'effectue de manière exponentielle décroissante, tel que prévu par la Loi de Beer Lambert. Sur 35 $\mu$m selon la direction De(z) (voir extrémité supérieure de la figure 7b), toute la lumière n'est pas absorbée.

Sur les figures 8a, 8b, on observe que toute la lumière est absorbée sur une distance de seulement 15 $\mu$m selon la direction De(z).

On voit ainsi clairement que la photodiode selon l'invention permet de réduire considérablement la longueur L du coeur 210 pour une sensibilité donnée.

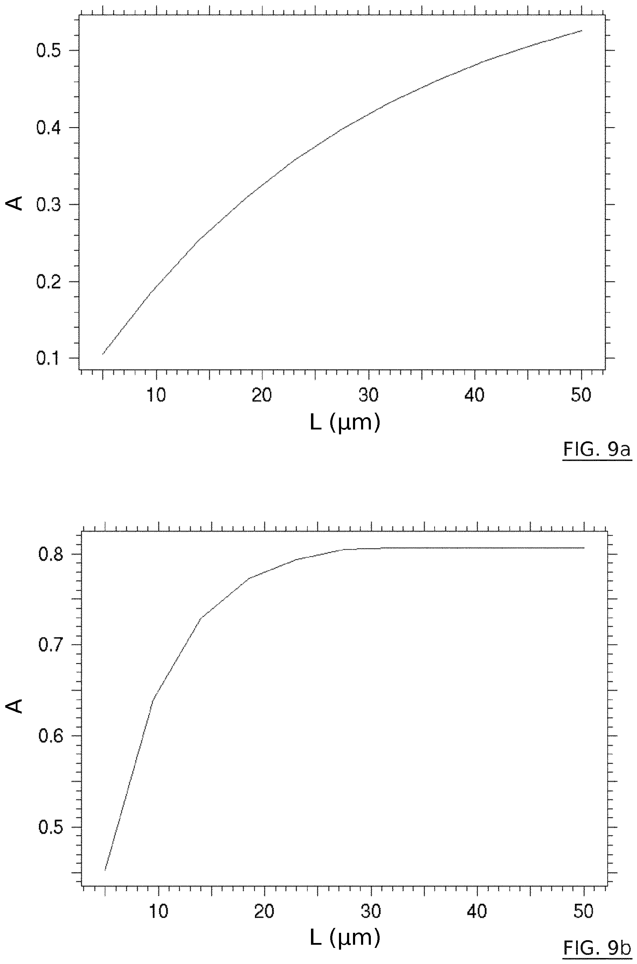

Ces performances améliorées ressortent également des figures 9a et 9b qui illustrent l'évolution de l'absorption de la lumière en fonction de la longueur L du coeur 210 pour respectivement une photodiode classique et celle de la présente invention.

On observe qu'une photodiode classique n'a absorbé que 50% de la lumière sur 50 $\mu$m alors que la photodiode selon l'invention atteint 50% d'absorption sur seulement 7 $\mu$m de longueur. Cette photodiode selon l'invention est donc sept fois plus absorbante alors même qu'elle contient trois fois moins de matériau absorbant (ici du germanium).

La bande passante est ainsi augmentée. Le bruit d'obscurité est réduit. Par ailleurs, si la photodiode est à avalanche, comme par exemple illustré en figures 6a, 6b, le bruit de multiplication est réduit.

Les principes de l'invention ont été décrits ci-dessus et l'homme du métier comprend aisément que des variantes peuvent être envisagées sans sortir de la portée des revendications.

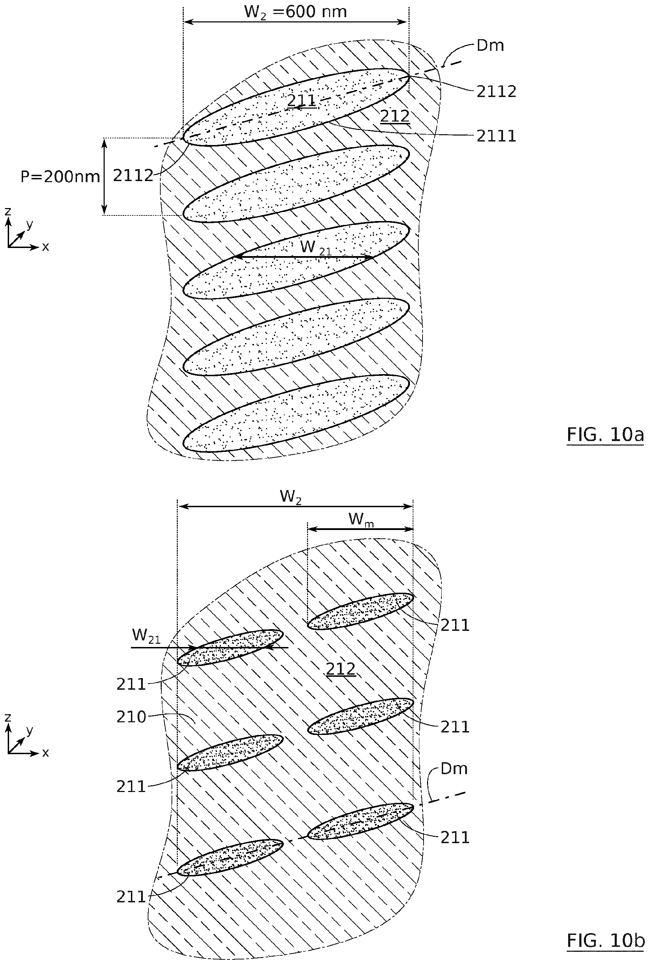

Deux variantes sont par exemple proposées en figures 10a et 10b.

En figure 10a, les motifs 211 sont formés non pas par des parallélogrammes comme sur les modes de réalisation des figures 5a à 6b, mais présentent des bords arrondis. Cette forme avec des bords arrondis permet de faciliter la réalisation des motifs 211.

Sur la figure 10a, cet arrondissement des bords est amplifié et les motifs 211 peuvent former des ellipses ou des formes oblongues. On pourra néanmoins identifier une direction d'extension principale Dm et des flancs 2111 s'étendant principalement dans cette direction.

La figure 10b illustre un mode de réalisation dans lequel plusieurs motifs 211 s'étendent selon une même direction Dm. La largeur Wm d'un motif 211 est donc inférieure à la largeur $W_2$ du coeur 210.

L'invention ne se limite pas à des matériaux particuliers pour le coeur et la gaine des guides 100, 200.

On pourra ainsi avoir pour le coeur 110 du silicium (Si) ou du nitrure de Silicium (SiN), et pour la gaine 120 du dioxyde de silicium ($SiO_2$), du silicium voire un gaz tel que l'air par exemple ou du vide.

On pourra avoir pour le matériau absorbant du coeur 210 du germanium de préférence intrinsèque (Ge-i) et pour la couche de confinement 212 du silicium. On pourra avoir pour la gaine 220 du silicium, de préférence dopé, du dioxyde de silicium ($SiO_2$), voire un gaz tel que l'air par exemple ou du vide.

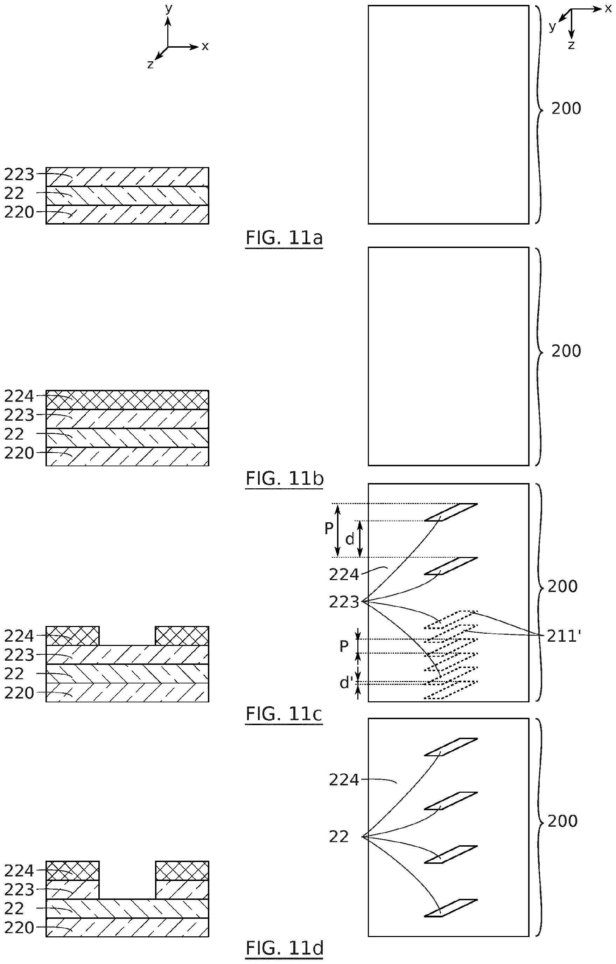

Un exemple de procédé de fabrication d'une photodiode illustrée en figure 5a à 6b va maintenant être décrit en référence aux figures 11a à 11g. Chacune des figures 11a à 11g comprend une vue en coupe de la portion d'absorption 200 (vue selon un plan xy) et une vue du dessus (vue parallèle au plan zx).

La première étape (figure 11a) consiste à fournir un empilement de couches comprenant notamment :

- un substrat 220, par exemple un matériau diélectrique tel que le $SiO_2$ ;
- une couche 22 surmontant le substrat 220 et destinée à former en partie au moins la gaine 220 pour le coeur 210. Cette couche 22 est de préférence, mais non limitativement, en un matériau semi-conducteur tel que le silicium.

Selon un mode de réalisation, cette couche 22 présente au moins deux zones dopées situées de part et d'autre de l'axe y. Ainsi, une zone située par exemple à gauche de l'axe y est dopée n et une autre zone située à droite de l'axe y est dopée p. Ces zones sont destinées à former les zones d'extraction de charges 221, 222. En outre, si la photodiode est à avalanche, on formera par absence de dopage et par dopage, respectivement la couche de multiplication 231 et le cas échéant la couche de charge 230 comme décrit en référence aux figures 6a et 6b.

- une couche 223, par exemple en un matériau diélectrique tel que le $SiO_2$, est destinée à former un masque dur

Les étapes illustrées en figure 11b à 11d visent à graver le masque dur 223 pour lui donner la structuration du coeur 210 de la portion d'absorption 200. Cette structuration apparaît en figures 11c et 11d. On y voit ainsi une pluralité de motifs 211 séparées mutuellement d'une distance d ou d'. Comme indiqué précédemment et illustré en figure 11c, pour certains modes de réalisation d peut être nulle ou positive et pour d'autres modes de réalisation d' peut être négative comme illustré par les motifs 211' en pointillés.

Pour former des motifs 211 par exemple, on dépose une couche de résine 224 (figure 11b) que l'on ouvre (figure 11c) par n'importe quel moyen approprié de lithographie (photolithographie, lithographie par faisceau d'électrons, nano-impression, etc...) afin de donner aux ouvertures la segmentation voulue pour le coeur 210 du guide d'absorption 200.

Sur les exemples des figures 11a à 11d les motifs forment des parallélogrammes. Dans la pratique, il sera plus aisé que les motifs aient des bords arrondis comme décrit en référence à la figure 10a.

Comme illustré par la figure 11d, on grave ensuite le masque dur 223 à travers le masque formé par la couche de résine 224 ouverte. On retire ensuite la couche de résine 224 (figure 11e). On grave alors la couche 22 destinée à former en partie la gaine 220 à travers le masque dur 223.

On procède ensuite à un remplissage de la cavité 540 ainsi formée par le matériau formant le coeur 210 de la portion d'absorption d'ondes 200 (figure 11g). Le coeur 210 présente alors la structuration souhaitée.

Selon un mode de réalisation, pour remplir le coeur 210, on procède à une croissance par épitaxie à partir d'une couche résiduelle 560 de la couche 22 laissée en place en fin de gravure.

Ainsi selon ce mode de réalisation la gravure de la couche 22 n'est que partielle et laisse une épaisseur 560 dans le fond de l'ouverture 540.

Par exemple, si le matériau de la couche 22 est du silicium cristallin ou polycristallin, on pourra remplir la cavité en faisant croître du germanium par épitaxie.

Si les motifs présentent des dimensions réduites, l'homme du métier pourra utiliser les nombreuses techniques qu'il connaît. Par ailleurs, on pourra se référer à la publication suivante, en particulier à la section 2, afin de faciliter le remplissage de la cavité 560 par un matériau absorbant tel que le germanium: « Zero-bias 40Gbit/s germanium waveguide photodetector on silicon » dont les auteurs sont Laurent Vivien, Andreas Polzer, Delphine Marris-Morini, Johann Osmond, Jean Michel Hartmann, Paul Crozat, Eric Cassan, Christophe Kopp, Horst Zimmermann, Jean Marc Fédéli. Cette publication a été publiée dans la revue OPTICS EXPRESS 1096, Vol. 20, du 16 janvier 2012.

De préférence, on effectue ensuite une étape d'aplanissement, par exemple par polissage mécano-chimique (CMP) pour que les faces supérieures de la couche 22 et du coeur 210 soient sensiblement comprises dans le même plan.

Ensuite il est possible de recouvrir les faces supérieures de la couche 22 et du coeur 210 par une couche protection, de préférence un diélectrique, par exemple une couche en SiO$_2$.

Il est ensuite possible de réaliser des contacts électriques 250, 251 au niveau des zones dopées par toutes les techniques largement connues de l'homme du métier, par exemple en réalisant des trous d'interconnexion puis en remplissant ces trous par un matériau électriquement conducteur.

Ce procédé a pour avantage d'être simple et parfaitement reproductible. Il permet ainsi de fabriquer la photodiode de manière simple et à un coût limité.

Au vu de la description qui précède, il apparaît clairement que l'invention propose une solution simple et aisément reproductible pour augmenter l'absorptivité d'une photodiode toute en réduisant sa longueur et donc tout en améliorant sa bande passante, ceci sans augmenter le courant d'obscurité et en réduisant l'excès de bruit de multiplication pour les photodiodes à avalanche.

L'invention n'est pas limitée aux modes de réalisations précédemment décrits et s'étend à tous les modes de réalisation couverts par les revendications.

**Revendications**

1. Photodiode comprenant au moins une portion d'absorption (200), la portion d'absorption (200) comportant au moins un coeur (210) entouré au moins en partie d'une gaine (220) comprenant au moins deux zones (221, 222) d'extraction de charges, le coeur (210) comprenant :

   ▪ une pluralité de motifs (211) formés d'un premier matériau ayant la propriété de générer, par absorption de photons, des porteurs de charges électriques libres;
   ▪ une couche de confinement (212) à l'intérieur de laquelle sont situés les motifs (211), la couche de confinement (212) étant formée d'un deuxième matériau différent du premier et apte à être rendu électriquement conducteur;

   **caractérisée en ce que**:

   ▪ les motifs sont disposés de manière périodique selon une direction principale De (z) d'extension dudit coeur (210), en présentant un pas p tel que :

   $$p \leq \frac{\lambda}{4}$$

   λ étant la plus petite longueur d'onde à détecter par la photodiode;
   ▪ les motifs (211) s'étendent principalement selon une direction Dm formant avec une direction Dp (x) perpendiculaire à ladite direction principale De (z) un angle θ tel que 90>θ>0 et de préférence 80>θ>10,
   ▪ la photodiode est configurée de manière à ce qu'une lumière à détecter soit incidente dans le coeur (210) selon ladite direction principale De (z).

2. Photodiode selon la revendication précédente dans laquelle le pas p est tel que $p \leq \frac{\lambda}{6}$ et de préférence $p \leq \frac{\lambda}{7}$.

3. Photodiode selon l'une quelconque des revendications précédentes dans laquelle l'angle θ est tel que 70>θ>5 et de préférence 60>θ>10 et de préférence 50>θ>15.

4. Photodiode selon l'une quelconque des revendications précédentes dans laquelle les motifs sont disposés de manière périodique selon une direction principale De (z) d'extension dudit coeur (210) en présentant un pas p tel que :

   $$p < \frac{\lambda}{2\,n_{eff}}$$

   n$_{eff}$ étant l'indice de réfraction effectif du mode, et n$_{eff}$ étant tel que :

   $$p \leq \frac{\lambda}{4}$$

5. Photodiode selon l'une quelconque des revendications précédentes dans laquelle les motifs sont disposés de manière périodique selon une direction principale De (z) d'extension dudit coeur (210) en présentant un pas p tel que p≤425 nm (10$^{-9}$ mètres), de préférence p≤400 nm, de préférence p≤280 nm.

6. Photodiode selon l'une quelconque des revendications précédentes dans laquelle les motifs du coeur (210) sont formés d'un matériau semi-conducteur intrinsèque tel que le germanium (Ge) et la couche de confinement est en silicium et lesdites zones d'extraction (221, 222) sont en silicium (Si) dopé p et n.

7. Photodiode selon l'une quelconque des revendications précédentes formant une photodiode à avalanche.

8. Photodiode selon l'une quelconque des revendications précédentes dans laquelle le coeur (210) et les zones (221, 222) d'extraction sont configurés de manière à ce que le déplacement de porteurs de charges électriques dans le coeur (210) s'effectue selon des directions parallèles à ladite direction Dp (x) et dans laquelle les motifs (211) présentent une hauteur h, prise selon la direction principale De(z), telle que 3p≥h≥0.5p , de préférence 1.5p≥h≥0.5p et de préférence h=p.

9. Photodiode selon l'une quelconque des revendications précédentes dans laquelle

$$\theta \leq \tan^{-1}(\frac{P}{W_2}),$$

$W_2$ étant la largeur du coeur (210) prise selon la direction Dp (x) et de préférence

$$\theta \approx \tan^{-1}(\frac{P}{W_2}).$$

10. Photodiode selon l'une quelconque des revendications précédentes, formant une photodiode à avalanche et comprenant une couche de multiplication (231) configurée pour favoriser la multiplication de porteurs de charge par impact, la couche de multiplication (231) étant disposée entre l'une des zones d'extraction (222) et le coeur (210) et la couche de multiplication (231) étant de préférence directement au contact du coeur (210) et de l'une des zones d'extraction (222).

11. Photodiode selon l'une quelconque des revendications 1 à 9, formant une photodiode à avalanche et comprenant une couche de multiplication (231) configurée pour favoriser la multiplication de porteurs de charge par impact, la couche de multiplication (231) étant disposée entre l'une des zones d'extraction (222) et le coeur (210), la photodiode comprenant également une couche de charge (230) disposée entre la couche de multiplication (231) et le coeur (210).

12. Photodiode selon l'une quelconque des revendications précédentes, dans laquelle le deuxième matériau formant la couche de confinement (212) est à base du même matériau qu'un matériau formant les zones d'extraction (221, 222).

13. Photodiode selon l'une quelconque des revendications précédentes dans laquelle la largeur $W_m$ des motifs (211) est égale à la largeur $W_2$ du coeur (210) de la portion d'absorption (200), la largeur $W_m$ des motifs étant mesurée en projection selon la direction Dp (x) et prise d'une extrémité (2112) à l'autre du motif (211).

14. Photodiode selon l'une quelconque des revendications précédentes:

- dans laquelle le coeur (210) de la portion d'absorption présente une largeur $W_2$ mesurée en projection selon la direction Dp (x), dans laquelle les motifs présentent des flancs (2111) sensiblement parallèles à ladite direction Dm, et dans laquelle les motifs présentent une dimension $W_{21}$ prise, d'un flanc (2111) à l'autre et selon la direction Dp (x) perpendiculaire à ladite direction principale De (z), avec $W_{21} \leq W_2/k$, et avec k≥1.5, de préférence k≥3,

et/ou

- dans laquelle les motifs présentent des flancs (2111) sensiblement parallèles à ladite direction Dm, et dans laquelle les motifs présentent une dimension $W_{21}$ prise, d'un flanc (2111) à l'autre et selon la direction Dp (x) perpendiculaire à ladite direction principale De (z), avec $W_{21} \leq p/m$, et avec m≥1, de préférence m≥1.5.

15. Dispositif micro-électronique comportant une pluralité de photodiodes selon l'une quelconque des revendications précédentes.

**Patentansprüche**

1. Fotodiode mit zumindest einem Absorptionsabschnitt (200), wobei der Absorptionsabschnitt (200) zumindest einen Kern (210) enthält, der zumindest teilweise von einer Hülle (220) umgeben ist, die zumindest zwei Ladungsextraktionsbereiche (221, 222) enthält, wobei der Kern (210) enthält:

   ▪ eine Vielzahl von Mustern (211), die aus einem ersten Material gebildet sind, das die Eigenschaft besitzt, durch Photonenabsorption Träger von freien elektrischen Ladungen zu erzeugen;
   ▪ eine Begrenzungsschicht (212), innerhalb derer sich die Muster (211) befinden, wobei die Begrenzungsschicht (212) aus einem zweiten Material gebildet ist, das sich von dem ersten unterscheidet und elektrisch leitfähig gemacht werden kann;

   **dadurch gekennzeichnet, dass**:

   ▪ die Muster periodisch in einer Haupterstreckungsrichtung De (z) des Kerns (210) angeordnet sind und dabei eine Teilung p aufweisen, so dass:

$$p \leq \frac{\lambda}{4}$$

wobei $\lambda$ die kleinste von der Fotodiode zu erfassende Wellenlänge ist;

■ die Muster (211) sich im Wesentlichen in einer Richtung Dm erstrecken, die mit einer Richtung Dp (x) senkrecht zu der Hauptrichtung De (z) einen Winkel $\theta$ einschließt, so dass $90 > \theta > 0$ und vorzugsweise $80 > \theta > 10$,

■ die Fotodiode so ausgelegt ist, dass ein zu erfassendes Licht in der Hauptrichtung De (z) in den Kern (210) einfällt.

2. Fotodiode nach dem vorangehenden Anspruch, wobei die Teilung p derart ist, dass $p \leq \frac{\lambda}{6}$ und vorzugsweise $p \leq \frac{\lambda}{7}$.

3. Fotodiode nach einem der vorangehenden Ansprüche, wobei der Winkel $\theta$ derart ist, dass $70 > \theta > 5$ und vorzugsweise $60 > \theta > 10$, bevorzugt $50 > \theta > 15$.

4. Fotodiode nach einem der vorangehenden Ansprüche, wobei die Muster periodisch in einer Haupterstreckungsrichtung De (z) des Kerns (210) angeordnet sind und dabei eine Teilung p aufweisen, so dass:

$$p < \frac{\lambda}{2n_{eff}}$$

wobei $n_{eff}$ der effektive Brechungsindex des Modus ist und $n_{eff}$ derart ist, dass

$$p \leq \frac{\lambda}{4}$$

5. Fotodiode nach einem der vorangehenden Ansprüche, wobei die Muster periodisch in einer Haupterstreckungsrichtung De (z) des Kerns (210) angeordnet sind und dabei eine Teilung p aufweisen, derart, dass $p \leq 425$ nm ($10^{-9}$ Meter), vorzugsweise $p \leq 400$ nm, bevorzugt $p \leq 280$ nm.

6. Fotodiode nach einem der vorangehenden Ansprüche, wobei die Muster des Kerns (210) aus einem intrinsischen Halbleitermaterial, wie etwa Germanium (Ge), gebildet sind und die Begrenzungsschicht aus Silicium besteht und die Extraktionsbereiche (221, 222) aus p- und n-dotiertem Silicium (Si) bestehen.

7. Fotodiode nach einem der vorangehenden Ansprüche, wobei sie eine Lawinenfotodiode bildet.

8. Fotodiode nach einem der vorangehenden Ansprüche, wobei der Kern (210) und die Extraktionsbereiche (221, 222) so ausgelegt sind, dass die Verlagerung der elektrischen Ladungsträger in dem Kern (210) in Richtungen parallel zur Richtung Dp (x) erfolgt, und wobei die Muster (211) eine Höhe h in der Hauptrichtung De(z) aufweisen, so dass $3p \geq h \geq 0,5\,p$, vorzugsweise $1,5\,p \geq h \geq 0,5\,p$ und bevorzugt h = p.

9. Fotodiode nach einem der vorangehenden Ansprüche, wobei $\theta \leq \tan^{-1}\left(\frac{P}{W_2}\right)$, wobei $W_2$ die Breite des Kerns (210) in Richtung Dp (x) und vorzugsweise $\theta \approx \tan^{-1}\left(\frac{P}{W_2}\right)$ ist.

10. Fotodiode nach einem der vorangehenden Ansprüche, wobei sie eine Lawinenfotodiode bildet und eine Vervielfachungsschicht (231) enthält, die dazu ausgelegt ist, die Vervielfachung von Ladungsträgern durch Aufprall zu begünstigen, wobei die Vervielfachungsschicht (231) zwischen einem der Extraktionsbereiche (222) und dem Kern (210) angeordnet ist und die Vervielfachungsschicht (231) vorzugsweise in direktem Kontakt mit dem Kern (210) und einem der Extraktionsbereiche (222) ist.

11. Fotodiode nach einem der Ansprüche 1 bis 9, wobei sie eine Lawinenfotodiode bildet und eine Vervielfachungsschicht (231) enthält, die dazu ausgelegt ist, die Vervielfachung von Ladungsträgern durch Aufprall zu begünstigen, wobei die Vervielfachungsschicht (231) zwischen einem der Extraktionsbereiche (222) und dem Kern (210) angeordnet ist, wobei die Fotodiode auch eine Ladungsschicht (230) enthält, die zwischen der Vervielfachungsschicht (231) und dem Kern (210) angeordnet ist.

12. Fotodiode nach einem der vorangehenden Ansprüche, wobei das die Begrenzungsschicht (212) bildende zweite Material auf Basis von dem gleichen Material wie ein Material, das die Extraktionsbereiche (221, 222) bildet, besteht.

13. Fotodiode nach einem der vorangehenden Ansprüche, wobei die Breite $W_m$ der Muster (211) gleich der Breite $W_2$ des Kerns (210) des Absorptionsbereichs (200) ist, wobei die Breite $W_m$ der Muster in Projektion in Richtung Dp (x) gemessen ist und von einem Ende (2112) des Musters (211) zum anderen genommen ist.

14. Fotodiode nach einem der vorangehenden Ansprüche, wobei

- der Kern (210) des Absorptionsabschnitts eine Breite $W_2$, gemessen in Projektion in Richtung Dp (x), aufweist, wobei die Muster mit ihren Flanken (2111) im Wesentlichen parallel zur Richtung Dm verlaufen und wobei die Muster eine Abmessung $W_{21}$ aufweisen, die von einer Flanke (2111) zu anderen und in Richtung Dp (x) senkrecht zur Hauptrichtung De (z) genommen ist, mit $W_{21} \leq W_2/k$ und mit $k \geq 1,5$ und vorzugsweise $k \geq 3$,
und/oder
- wobei die Muster mit ihren Flanken (2111) im Wesentlichen parallel zur Richtung Dm verlaufen und wobei die Muster eine Abmessung $W_{21}$ aufweisen, die von einer Flanke (2111) zu anderen und in Richtung Dp (x) senkrecht zur Hauptrichtung De (z) genommen ist, mit $W_{21} \leq p/m$ und mit $m \geq 1$ und vorzugsweise $m \geq 1,5$.

15. Mikroelektronische Vorrichtung mit einer Mehrzahl von Fotodioden nach einem der vorangehenden Ansprüche.


**Claims**

1. Photodiode comprising at least one absorption portion (200), the absorption portion (200) comprising at least one core (210) surrounded by at least one portion of a sleeve (220) comprising at least two zones (221, 222) for extracting charges, the core (210) comprising:

   * a plurality of patterns (211) formed from a first material having the property of generating, by absorbing photons, free electrical charge carriers;
   * a confinement layer (212) inside which are situated the patterns (211), the confinement layer (212) being formed from a second material, different from the first, and capable of being made electrically conductive;

   **characterised in that**:

   * the patterns are arranged periodically along a main direction De (z) of extension of said core (210), by having a step p such that:

$$p \leq \frac{\lambda}{4}$$

   $\lambda$ being the smallest wavelength to be detected by the photodiode;
   * the patterns (211) extend mainly along a direction Dm forming with a direction Dp (x) perpendicular to said main direction De (z), an angle

$\Theta$, such that $90 > \Theta > 0$, and preferably $80 > \Theta > 10$,
   * the photodiode is configured such that a light to be detected is incident in the core (210) along said main direction De (z).

2. Photodiode according to the preceding claim, wherein the step p is such that $p \leq \frac{\lambda}{6}$ and preferably $p \leq \frac{\lambda}{7}$.

3. Photodiode according to any one of the preceding claims, wherein the angle $\Theta$ is such that $70 > \Theta > 5$ and preferably $60 > \Theta > 10$ and preferably $50 > \Theta > 15$.

4. Photodiode according to any one of the preceding claims, wherein the patterns are arranged periodically along a main direction De (z) of extension of said core (210) by having a step p such that:

$$p < \frac{\lambda}{2\, n_{eff}}$$

   $n_{eff}$ being the actual refraction index of the mode, and $n_{eff}$ being such that:

$$p \leq \frac{\lambda}{4}$$

5. Photodiode according to any one of the preceding claims, wherein the patterns are arranged periodically along a main direction De (z) of extension of said core (210) by having a step p such that $p \leq 425nm$ ($10^{-9}$ metres), preferably $p \leq 400nm$, preferably $p \leq 280nm$.

6. Photodiode according to any one of the preceding claims, wherein the patterns of the core (210) are formed from an intrinsic semi-conductive material such as germanium (Ge) and the confinement layer is made of silicon and said extraction zones (221, 222) are made of doped silicon (Si) p and n.

7. Photodiode according to any one of the preceding claims forming an avalanche photodiode.

8. Photodiode according to any one of the preceding claims, wherein the core (210) and the extraction zones (221, 222) are configured such that the movement of electrical charge carriers in the core (210) is made along directions parallel to said direction Dp (x) and wherein the patterns (211) have a height h, taken along the main direction De (z), such that $3p \geq h \geq 0.5p$, preferably $1.5p \geq h \geq 0.5p$, and preferably $h=p$.

9.  Photodiode according to any one of the preceding claims, wherein $\theta \leq \tan^{-1}(\dfrac{P}{W_2})$, $W_2$ being the width of the core (210) taken along the direction Dp (x) and preferably $\theta \approx \tan^{-1}(\dfrac{P}{W_2})$.

10. Photodiode according to any one of the preceding claims, forming an avalanche photodiode and comprising a multiplication layer (231) configured to favour the multiplication of charge carriers by impact, the multiplication layer (231) being arranged between one of the extraction zones (222) and the core (210) and the multiplication layer (231) being preferably directly in contact with the core (210) and one of the extraction zones (222).

11. Photodiode according to any one of claims 1 to 9, forming an avalanche photodiode and comprising a multiplication layer (231) configured to favour the multiplication of charge carriers by impact, the multiplication layer (231) being arranged between one of the extraction zones (222) and the core (210), the photodiode also comprising a charge layer (230) arranged between the multiplication layer (231) and the core (210).

12. Photodiode according to any one of the preceding claims, wherein the second material forming the confinement layer (212) is based on the same material as a material forming the extraction zones (221, 222).

13. Photodiode according to one of the preceding claims, wherein the width $W_m$ of the patterns (211) is equal to the width $W_2$ of the core (210) of the absorption portion (200), the width $W_m$ of the patterns being measured projecting along the direction Dp (x) and taken from one end (2112) to the other of the pattern (211).

14. Photodiode according to any one of the preceding claims:

    - wherein the core (210) of the absorption portion has a width $W_2$ measured projecting along the direction Dp (x), wherein the patterns have flanks (2111) substantially parallel to said direction Dm, and wherein the patterns have a dimension $W_{21}$ taken, from one flank (2111) to the other and along the direction Dp (x) perpendicular to said main direction De (z), with $W_{21} \leq W_2/k$, and with $k \geq 1.5$, preferably $k \geq 3$, and/or
    - wherein the patterns have flanks (2111) substantially parallel to said direction Dm, and wherein the patterns have a dimension $W_{21}$ taken, from one flank (2111) to the other and along the direction Dp (x) perpendicular to said main direction De (z), with $W_{21} \leq p/m$, and with $m \geq 1$, preferably $m \geq 1.5$.

15. Microelectronic device comprising a plurality of photodiodes according to any one of the preceding claims.

FIG. 1

FIG.2a

FIG. 2b

FIG. 2c

100    200

Si$_{p+}$    Ge$_i$    Si$_p$    Si$_i$    Si$_{n+}$

120    Guide Si    250
       110    222
       110    210
              230
              231
              221
              251

$y$
$z$
$x$

FIG. 3a

250    222    210    230    231    251
       221
       240

Si$_{p+}$    Ge$_i$    Si$_p$    Si$_i$    Si$_{n+}$

$y$
$x$
$z$

FIG. 3b

FIG. 4a

FIG. 4b

FIG. 5a

Détail A

FIG. 5b

De

221  210  230  231  222

Si$_p$  S$_i$

z y x

Ge$_i$

Si$_{p+}$  Si$_{n+}$

B

200

211

212

L

100

SiO$_2$  Si  SiO$_2$'

120  110

FIG. 6a

210

z y x

W$_2$=600 nm

w$_{21}$=200 nm

212  2112

h= 200 nm

211  θ  2111

61  200 nm  62  Détail B

FIG. 6b

FIG. 7a

FIG. 7b

FIG. 8a

FIG. 8b

FIG. 9a

FIG. 9b

FIG. 10a

FIG. 10b

FIG. 11a

FIG. 11b

FIG. 11c

FIG. 11d

FIG. 11e

FIG. 11f

FIG. 11g

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20160254407 A

**Littérature non-brevet citée dans la description**

- **LAURENT VIVIEN ; ANDREAS POLZER ; DELPHINE MARRIS-MORINI ; JOHANN OSMOND ; JEAN MICHEL HARTMANN ; PAUL CROZAT ; ERIC CASSAN ; CHRISTOPHE KOPP ; HORST ZIMMERMANN ; JEAN MARC FÉDÉLI.** Zero-bias 40Gbit/s germanium waveguide photodetector on silicon. *OPTICS EXPRESS 1096,* 16 Janvier 2012, vol. 20